# EUROPÄISCHE PATENTANMELDUNG

(11) **EP 3 629 037 A1**
(43) Veröffentlichungstag der Anmeldung: **01.04.2020**
(21) Anmeldenummer: 18197525.1
(22) Anmeldetag: 28.09.2018
(51) Int. Cl.: G01R 31/02, H02H 1/00, H02H 3/33

(54) **AFCI SELBSTTEST**

(71) Anmelder: FRONIUS INTERNATIONAL GmbH, 4643 Pettenbach (AT)
(72) Erfinder: Hofer, Bernd, 4643 Pettenbach (AT); Breuer, Stefan, 4643 Pettenbach (AT); Fasthuber, Christian, 4643 Pettenbach (AT); Spitzer, Walter, 4643 Pettenbach (AT); Hofer, Andreas, 4643 Pettenbach (AT)
(74) Vertreter: Patentanwälte Pinter & Weiss OG

(57) **Zusammenfassung**

Um einen Fehler (F) in einer Anordnung, umfassend einen Transformator (2), welcher eine in Serie zu einer Gleichspannungsleitung (DC+, DC-) geschaltete Primärwicklung (L1) und eine mit der Primärwicklung (L1) magnetisch gekoppelte Sekundärwicklung (L2) aufweist, und umfassend eine Auswerteeinheit (5), welche ein Sekundärsignal (i2) auf der Sekundärwicklung (L2) verarbeitet, zu erkennen wird erfindungsgemäß aus dem Sekundärsignal (i2) ein Signalanteil (n(fn)) bei zumindest einer Frequenz (fn) ermittelt und ein Signalpegel (P(fn)) des Signalanteils (n(fn)) mit einer Signalschwelle (P_min(fn)) verglichen. Der der Fehler (F) wird detektiert, wenn der Signalpegel (P(fn)) die Signalschwelle (P_min(fn)) unterschreitet.

## Beschreibung

Die gegenständliche Erfindung betrifft ein Verfahren zur Detektion eines Fehlers in einer Anordnung, umfassend einen Transformator, welcher eine in Serie zu einer Gleichspannungsleitung geschaltete Primärwicklung und eine mit der Primärwicklung magnetisch gekoppelte Sekundärwicklung aufweist und umfassend eine Auswerteeinheit, welche ein Sekundärsignal auf der Sekundärwicklung verarbeitet. Weiters betrifft die gegenständliche Erfindung eine Anordnung umfassend einen Transformator, aufweisend eine Primärwicklung, welche in Serie zu einer Gleichspannungsleitung geschaltet ist und aufweisend eine mit der Primärwicklung magnetisch gekoppelte Sekundärwicklung und umfassend eine Auswerteeinheit welche ausgestaltet ist ein Sekundärsignal auf der Sekundärwicklung zu verarbeiteten.

Es wird in Gleichspannungsanlagen eine Gleichspannung von zumindest einer Gleichspannungsquelle zur Verfügung gestellt und über Gleichspannungsleitungen an eine Gleichspannungssenke übertragen. Als Gleichspannungsquellen kann beispielsweise eine Anzahl von Solarpanelen, bzw. Solarzellen einer Photovoltaikanlage oder eine Batterie zur Verfügung stehen. Es wird dabei an den Solarpanelen, bzw. Solarzellen die Gleichspannung in Abhängigkeit von der jeweiligen Sonneneinstrahlung erzeugt. Als Gleichspannungssenke kann beispielsweise ein Wechselrichter dienen. Ein Wechselrichter wandelt die Gleichspannung in eine Wechselspannung und kann diese in ein elektrisches Versorgungsnetz einspeisen oder die erzeugte Wechselspannung einer elektrischen Last, wie z.B. einer elektrische Maschine oder einer Batterie, zur Verfügung stellen.

Es ist in vielen Anordnungen eine Kommunikation mit den vorhandenen Gleichspannungsquellen und/oder Gleichspannungssenken erwünscht. Von einer Steuereinheit gesendete Kommunikationssignale können beispielsweise zur Synchronisierung von einzelnen Solarpanels dienen. Insbesondere bei Auftreten eines Fehlerfalls können Kommunikationssignale auch zum Abschalten von Gleichspannungsquellen oder anderen Elementen der Anordnung dienen. Kommunikationssignale können somit beispielsweise über eigens vorgesehenen Kommunikationsleitungen oder aber direkt über die vorhandene Gleichspannungsleitungmittels sogenannter Powerline-Kommunikation (Power Line Communication, PLC) - übertragen werden. Bei einer Powerline-Kommunikation werden bekanntermaßen PLC-Signale bei einer PLC-Frequenz auf die zur Energieübertragung vorhandene Gleichspannung als Grundsignal aufmoduliert und übertragen. Es können somit Transformatoren zur Einkopplung und/oder Auskopplung der PLC-Signale auf die Gleichspannungsleitung verwendet werden, wobei eine Primärwicklung in Serie mit der Gleichspannungsleitung verbunden wird. Der Transformator transformiert ein durch die Primärwicklung fließendes wechselförmiges Primärsignal auf ein in der Sekundärwicklung fließendes wechselförmiges Sekundärsignal und umgekehrt. Es ist weiters eine PLC-Empfangseinheit bzw. PLC-Sendeeinheit mit der Sekundärwicklung zum Empfangen, bzw. Senden des PLC-Signals verbunden. Weitere Empfangseinheiten bzw. Sendeeinheiten können sich auf mit der Gleichspannungsleitung verbundenen Gleichspannungsquellen und/oder Gleichspannungssenken befinden.

Es kann ein Transformator auch zur Erkennung eines Lichtbogens verwendet werden, wenn eine Lichtbogendetektionseinheit mit der Sekundärwicklung des Transformators verbunden ist. Tritt ein Lichtbogen auf, so wird ein Lichtbogensignal als Teil des Primärsignals vom Transformator von der Primärwindung auf das Sekundärsignal auf der Sekundärwicklung transformiert. Die Lichtbogendetektionseinheit analysiert das Sekundärsignal und erkennt einen Signalteil mit einer bestimmten oder Signalteile mit verschiedenen Lichtbogenfrequenzen eines durch den Transformator auf die Sekundärseite transformierten Lichtbogensignals. Damit kann auf ein Auftreten eines Lichtbogens geschlossen werden. Es kann auch ein bereits für die PLC-Kommunikation vorhandener Transformator zur Lichtbogenerkennung verwendet werden, wenn das Lichtbogensignal auf der Sekundärseite vom gesendeten PLC-Signal unterschieden wird.

Es ist jedoch oftmals erforderlich, dass eine Anordnung, umfassend den Transformator und eine Auswerteeinheit, fehlerfrei ist, beispielsweise um sicherzustellen, dass die Lichtbogenerkennung und/oder die PLC-Kommunikation funktioniert.

Es ist somit eine Aufgabe der gegenständlichen Erfindung einen Fehler in einer Anordnung, umfassend einen Transformator zum Transformieren eines Primärsignals einer Gleichspannungsleitung in ein Sekundärsignal und umfassend eine Auswerteinheit zum Auswerten des Sekundärsignals, zu erkennen.

Diese Aufgabe wird erfindungsgemäß durch ein Verfahren und eine Fehlerdetektionseinheit gelöst, wobei aus dem Sekundärsignal einen Signalanteil bei zumindest einer Frequenz ermittelt wird, ein Signalpegel des Signalanteils mit einer Signalschwelle verglichen wird und der Fehler in der Anordnung detektiert wird, wenn der Signalpegel die Signalschwelle unterschreitet. Es kann somit die Anordnung, insbesondere der Transformator, oder ein Teil der Auswerteeinheit, auf Fehlerfreiheit geprüft werden. Ist beispielsweise die Primärwicklung und/oder die Sekundärwicklung des Transformators defekt, so ist der Signalpegel des Signalanteils bei zumindest einer bestimmten Frequenz unter der Signalschwelle. Wird dies erfindungsgemäß detektiert, so kann auf einen Fehler in der Anordnung geschlossen werden. Als Fehler kann auch eine unterbrochene Leitung und/oder eine fehlerhafte Auswerteeinheit, z.B. ein defekter Verstärker, vorliegen. Es können natürlich unterschiedliche Signalschwellen für unterschiedliche Frequenzen vorgesehen sein.

Der Transformator kann ein wechselförmiges Primärsignal über eine in Serie zu einer Gleichspannungsleitung geschaltete Primärwicklung aus der Gleichspannungsleitung auskoppeln und auf eine Sekundärwicklung transformieren. Gleichermaßen kann der Transformator auch ein wechselförmiges Sekundärsignal auf ein wechselförmiges Primärsignal auf der Primärwicklung transformieren und in die Gleichspannungsleitung einkoppeln.

Vorteilhafterweise wird als zumindest eine Frequenz zumindest eine an der Sekundärwicklung typisch auftretende Rauschfrequenz der fehlerfreien Anordnung und als Signalschwelle ein bei der typisch auftretenden Rauschfrequenz auftretender Rauschpegel der fehlerfreien Anordnung herangezogen. Damit kann als Signalanteil ein Rauschen bei einer Rauschfrequenz betrachtet werden. Unterschreitet der Signalpegel (der Rauschpegel) bei der zumindest einen Frequenz (der Rauschfrequenz) eine Signalschwelle, so kann auf einen Fehler geschlossen werden. Es wird somit ein Rauschen positiv genutzt, indem die Abwesenheit eines Rauschens im Sekundärsignal als Indikator für einen Fehler in der Anordnung verwendet wird.

Der Signalanteil kann bei einer Mehrzahl an Frequenzen eines Frequenzbandes, ermittelt und der Signalpegel bei der Mehrzahl an Frequenzen jeweils mit einer Signalschwelle verglichen werden. Damit umfasst der Signalanteil mehrere Frequenzen, wobei der Signalpegel bei diesen mehreren Frequenzen jeweils mit einer Signalschwelle (welcher für die mehreren Frequenzen identisch sein kann, aber nicht muss) verglichen wird. Bei Unterschreiten einer Signalschwelle durch einen Signalpegel kann auf einen Fehler geschlossen werden.

Vorteilhafterweise wird der Signalanteil bei einer Mehrzahl an Frequenzen eines Frequenzbandes ermittelt, ein Mittelwert der Signalpegel bei der Mehrzahl an Frequenzen gebildet und mit einer Signalschwelle verglichen. Durch diese Mittelwertbildung kann eine Störung auf einer Frequenz im Frequenzband ignoriert werden. Ansonsten könnte eine derartige Störung ein Unterschreiten der Signalschwelle durch den Signalpegel bei dieser Frequenz bewirken, obwohl kein Fehler auftritt. Durch die Betrachtung aller Signalpegel der Frequenzen im Frequenzband und die Mittelwertbildung wird der Gesamtenergieinhalt im Frequenzband betrachtet und ausgewertet.

Vorzugsweise reicht das Frequenzband von 0 Hz bis zu einer Grenzfrequenz, vorzugsweise 40 kHz.

Vorteilhafterweise wird der Signalanteil bei einem Start der Anordnung ermittelt. Damit kann sichergestellt werden, dass die Auswerteeinheit und der Transformator bei Inbetriebnahme korrekt funktionieren und kein Fehler auftritt. Selbstverständlich kann der Signalanteil bzw. der Pegel des Signalanteils auch im Betrieb der Anordnung ermittelt werden.

Die Auswerteeinheit kann durch die Fehlererkennungseinheit selbst repräsentiert werden oder die Fehlererkennungseinheit umfassen.

Die Auswerteeinheit kann eine Lichtbogendetektionseinheit und/oder eine PLC-Empfangseinheit umfassen, die ausgestaltet ist ein durch den Transformator von der Primärwicklung auf die Sekundärwicklung transformiertes Lichtbogensignal und/oder PLC-Empfangssignal zu empfangen.

Es kann auch eine Sendeeinheit vorgesehen sein, die mit der Sekundärwicklung des Transformators verbunden ist und ausgestaltet ist ein PLC-Sendesignal an die Sekundärwicklung zu senden. Der Transformator ist dann ausgestaltet, das PLC-Sendesignal von der Sekundärwicklung auf die Primärwicklung zu transformieren. Eine Empfangseinheit an einer Gleichspannungsquelle oder Gleichspannungssenke kann das aufmodulierte PLC-Sendesignal durch Demodulation rückgewinnen und auswerten.

Die Gleichspannungsleitung kann zur Übertragung einer Gleichspannung von zumindest einer Gleichspannungsquelle an zumindest eine Gleichspannungssenke vorgesehen sein.

Die zumindest eine Gleichspannungsquelle kann zumindest eine Photovoltaikzelle umfassen und die zumindest eine Gleichspannungssenke zumindest einen Wechselrichter umfassen.

Vorzugsweise wird aus dem Sekundärsignal ein weiterer Signalanteil bei zumindest einer weiteren Frequenz ermittelt und ein Signalpegel des weiteren Signalanteils mit einer oberen Signalschwelle verglichen. Der Fehler in der Anordnung wird detektiert, wenn der Signalpegel die obere Signalschwelle unterschreitet.

Die zumindest eine weitere Frequenz kann der zumindest einen Frequenz entsprechen, womit der weitere Signalanteil dem Signalanteil entspricht.

Die gegenständliche Erfindung wird nachfolgend unter Bezugnahme auf die Figuren 1 bis 6 näher erläutert, die beispielhaft, schematisch und nicht einschränkend vorteilhafte Ausgestaltungen der Erfindung zeigen. Dabei zeigt
Fig.1a eine erfindungsgemäße Anordnung ohne auftretenden Fehler,
Fig.1b eine erfindungsgemäße Anordnung mit auftretendem Fehler,
Fig.2 eine Anordnung geeignet zum Empfangen eines PLC-Empfangssignals,
Fig.3 eine Anordnung geeignet zur Detektion eines Lichtbogens,
Fig.4 eine Anordnung geeignet zum Senden eines PLC-Empfangssignals und zur Detektion eines Lichtbogens,
Fig.5 eine Anordnung geeignet zum Senden eines PLC-Empfangssignals und zur Detektion eines Lichtbogens mit auftretendem Kurzschluss,
Fig.6 einen typischen Frequenzbereich des Sekundärsignals.

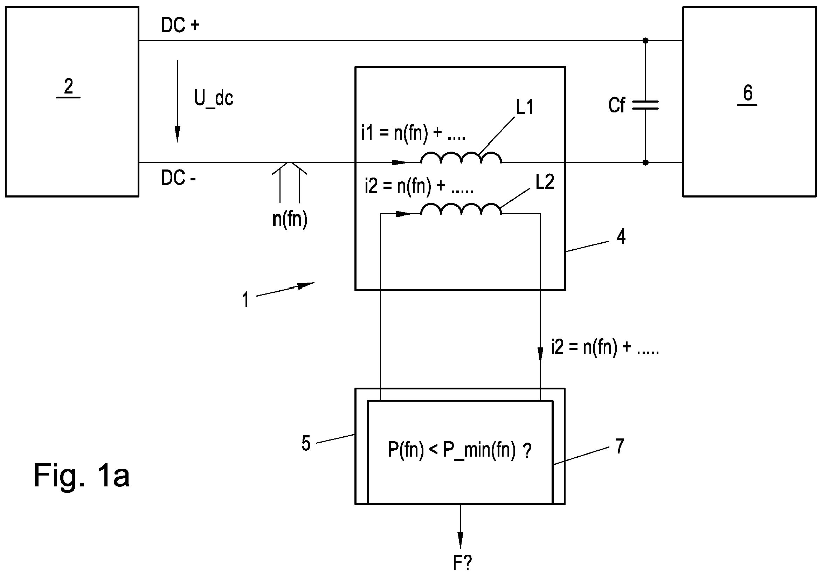

In den Fig. 1a bis 4 ist jeweils eine Gleichspannungsquelle 2 und eine Gleichspannungssenke 6 dargestellt, welche über eine positive Gleichspannungsleitung DC+ und eine negative Gleichspannungsleitung DC- miteinander verbunden sind. Die Gleichspannungsquelle 2 kann beispielsweise eine oder mehrere Solarzellen umfassen und stellt Energie zur Verfügung, welche als Gleichspannung U_dc an die Gleichspannungssenke 6 übertragen wird. Die Gleichspannungssenke 6 kann beispielsweise einen Wechselrichter, einen Gleichrichter, einen Hoch- und/oder Tiefsetzsteller, DC-DC-Wandler, bidirektionale Wandler, usw. umfassen und zum Einspeisen in ein Energieversorgungsnetz oder zur Energieversorgung eines Verbrauchers dienen. Als Gleichspannungssenke 6 kann natürlich auch direkt ein elektrischer Verbraucher angesehen werden. Insbesondere in Photovoltaikanlagen können unterschiedliche Konfigurationen von Gleichspannungsquellen 2 und Gleichspannungssenken 6 vorgesehen sein, so kann beispielsweise jedes Solarpanel als Gleichspannungsquelle 2 über eine Gleichspannungsleitung DC+, DC- mit einem Wechselrichter als Gleichspannungssenke 6 verbunden sein. Es können sich mehrere Gleichspannungsquellen 2 und/oder Gleichspannungssenken 6 auch Teile der Gleichspannungsleitungen DC+, DC- teilen. Solarpanels als Gleichspannungsquelle 2 können zudem auch seriell und/oder parallel miteinander verschaltet sein. Es sind somit diverse Konfigurationen an Gleichspannungsquellen 2, Gleichspannungssenken 6 und Gleichspannungsleitungen DC+, DC- vorstellbar, womit die Erfindung natürlich nicht auf die Konfiguration in den Figuren eingeschränkt ist. Bei Verwendung von Batterien können die Batterien als Gleichspannungsquellen 2 oder Gleichspannungssenken 6 angesehen werden, je nachdem ob die Batterien entladen oder geladen werden. So kann je nach Betriebsart beispielsweise ein Wechselrichter bzw. Ladegerät als Gleichspannungsquelle 2 für eine Batterie als Gleichspannungssenke 6 dienen oder eine Batterie als Gleichspannungssenke 6 für einen Wechselrichter bzw. ein Ladegerät als Gleichspannungsquelle 2.

Es in den Fig. 1a bis 4 zudem eine erfindungsgemäße Anordnung 1 vorgesehen, welche einen Transformator 4, eine Auswerteeinheit 5 und eine Fehlerdetektionseinheit 7 umfasst. Der Transformator 4 umfasst eine Primärwicklung L1 auf einer Primärseite und eine Sekundärwicklung L2 auf einer Sekundärseite. Die Primärwicklung L1 ist hier in Serie mit der negativen Gleichspannungsleitungen DC- verbunden, die Sekundärwicklung L2 ist mit einer Auswerteeinheit 5 verbunden. Die Primärwicklung L1 könnte natürlich auch mit der positiven Gleichspannungsleitung DC+ verbunden sein.

Ein durch die Primärwicklung L1 fließendes wechselförmiges Primärsignal i1, vorzugweise ein Primärstrom, wird im Normalbetreib über den Transformator 4 auf ein durch die Sekundärwicklung L2 fließendes wechselförmiges Sekundärsignal i2, vorzugsweise ein Sekundärstrom i2, transformiert und umgekehrt. Vorteilhafterweise hat der Transformator 4 ein Übersetzungsverhältnis von 1:1, 1:2 oder 1:4 von der Primärseite auf die Sekundärseite. Weiters kann der Kommunikationstransformator 4 einen Ferritkern, z.B. einen Hiflux-Kern, vorzugsweise mit einem besonders vorteilhaften Sättigungsverhalten für Gleichströme aufweisen.

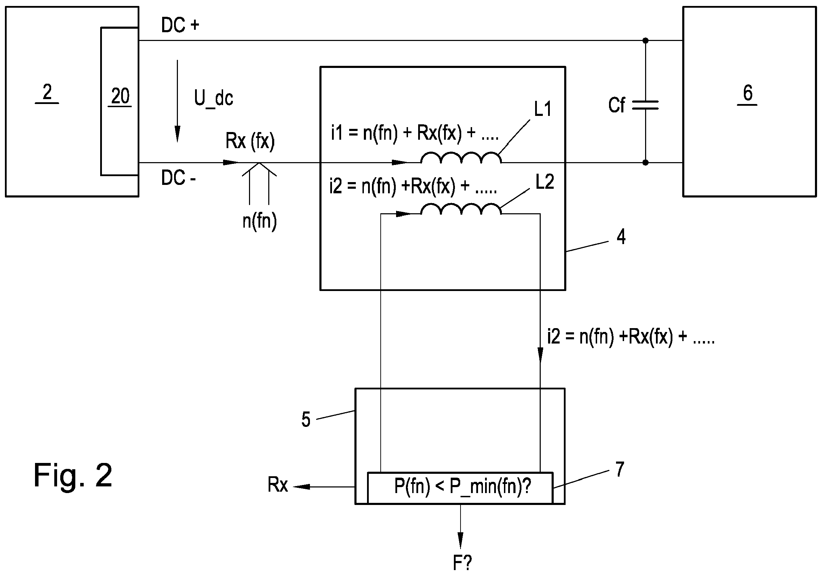

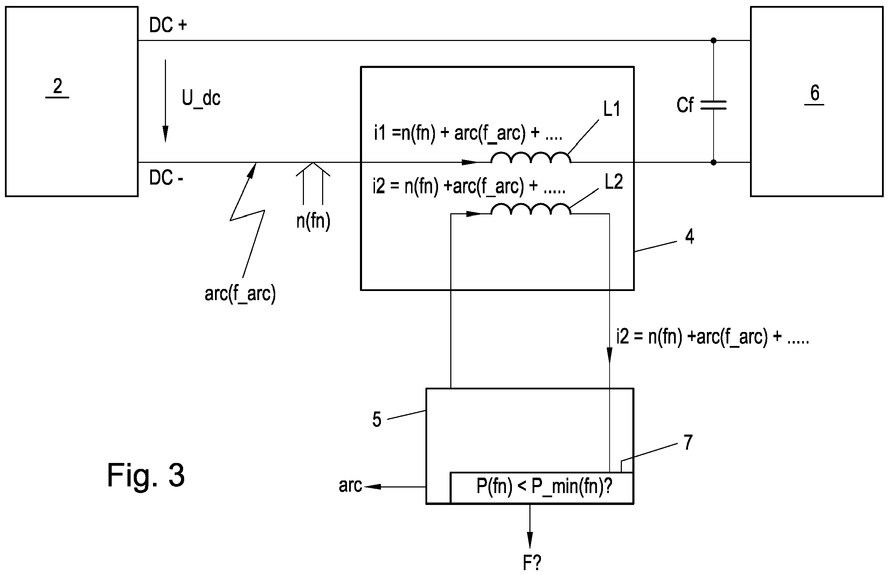

Die Auswerteeinheit 5 ist dazu ausgelegt das Sekundärsignal i2, welches an der Sekundärwicklung L2 anliegt, auszuwerten. So kann beispielsweise durch den Transformator 4 von der Primärwicklung L1 auf die Sekundärwicklung L2 transformiertes PLC-Empfangssignal Rx(fx) und/oder Lichtbogensignal arc(f_arc) empfangen und verarbeitet werden, wie weiter unten anhand der Fig. 2 und 3 beschrieben.

In den Figuren wird beispielhaft angenommen, dass der Transformator 4 ein Übersetzungsverhältnis von 1:1 aufweist, womit bei funktionsfähigem Transformator 4 das Primärsignal i1 dem Sekundärsignal i2 entspricht. Damit sind Primärsignal i1 und Sekundärsignal i2 bei funktionsfähigem Transformator 4 grundlegend identisch, womit die Frequenzen fn, Lichtbogenfrequenzen f_arc, PLC-Frequenzen fx, etc., auf der Primärseite und Sekundärseite identisch sind - was jedoch nur zur einfacheren Darstellung angenommen wurde.

Erfindungsgemäß ist die Sekundärwicklung L2 des Transformators 4 mit einer Fehlerdetektionseinheit 7 verbunden. Die Fehlerdetektionseinheit 7 kann einen Teil der Auswerteeinheit 5 darstellen oder auch selbst als Auswerteeinheit 5 angesehen werden. Die Fehlerdetektionseinheit 7 ermittelt aus dem Sekundärsignal i2 einen Signalanteil n(fn) bei zumindest einer Frequenz fn. Der Signalanteil i2(fn) weist einen Signalpegel P(fn) auf, welcher mit einer Signalschwelle P_min(fn) verglichen wird. Es wird ein Fehler F in der Anordnung 1 detektiert, wenn der Signalpegel P(fn) die Signalschwelle P_min(fn) unterschreitet. Als Fehler F kann beispielsweise ein Defekt in der Primärwicklung L1, der Sekundärwicklung L2 oder auch in der Auswerteeinheit 5, bzw. der Fehlerdetektionseinheit 7 auftreten.

Vorteilhafterweise wird als Signalanteil n(fn) ein typisch auftretender Rauschanteil des Sekundärsignals i2 der fehlerfreien Anordnung 1 betrachtet. Damit entspricht die zumindest eine Frequenz fn einer ein an der Sekundärwicklung L2 typisch auftretenden Rauschfrequenz. Es kann dementsprechend als Signalschwelle P_min(fn) ein in der fehlerfreien Anordnung 1 bei der zumindest einen Frequenz fn (d.h. der Rauschfrequenz) zu erwartender, da typisch auftretender, Rauschpegel verwendet werden.

In den Fig. 1a bis 4 ist der Signalanteil n(fn) beispielhaft als Pfeil in der negativen Gleichspannungsleitung DC- dargestellt. Damit wird in den Figuren der Signalanteil n(fn) von der Primärwicklung L1 auf die Sekundärwicklung L2 transformiert. Natürlich könnte der Signalanteil n(fn) auch zum Teil (z.B. bei gewissen Frequenzen fn) oder vollständig auf der Sekundärseite, z.B. an der Sekundärwicklung L2 oder in der Auswerteeinheit 5 entstehen.

Tritt nun kein Fehler F in der Anordnung 1 auf, so weist der Signalanteil n(fn) bei der zumindest einen Frequenz fn einen Signalpegel P(fn) über der Signalschwelle P_min(fn) auf, wie in Fig. 1a dargestellt. Damit wird kein Fehler F detektiert.

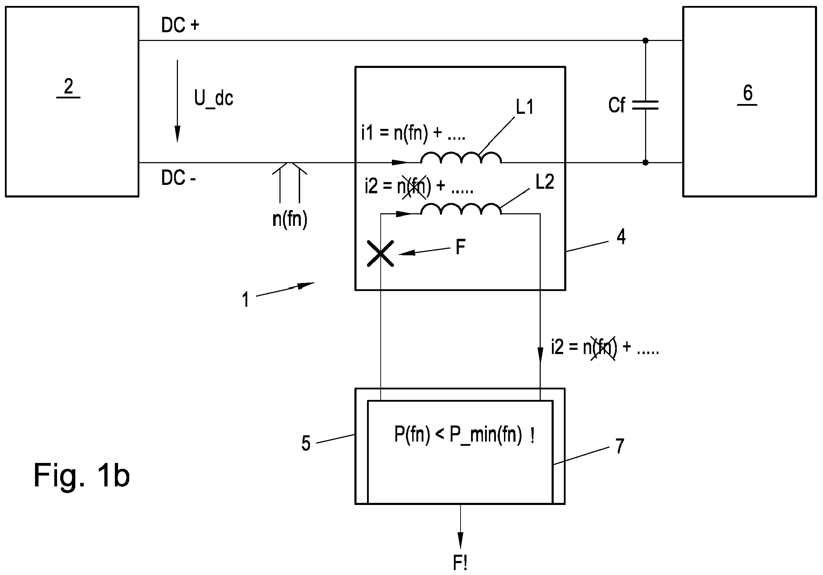

Tritt, wie in Fig. 1b dargestellt, ein Fehler F in der Anordnung 1 auf, so weist der der Signalanteil n(fn) einen Signalpegel P(fn) unter der Signalschwelle P_min(f2) auf. In Fig.1a ist der Signalanteil n(fn) beispielsweise nicht mehr im Sekundärsignal i2 enthalten, da die Leitung der Sekundärwicklung L2 unterbrochen ist (eigentlich ist hier damit das gesamte Sekundärsignal i2 unterbrochen). Damit kann somit in der Fehlerdetektionseinheit 7 auf das Vorhandensein eines Fehlers F geschlossen werden.

Die erfindungsgemäße Fehlererkennungseinheit 7 kann mit verschiedenen Transformatoren 4 kombiniert werden. Beispielsweise kann der Transformator 4, wie in Fig. 2 dargestellt, als PLC-Transformator vorgesehen sein. Ein PLC-Empfangssignal Rx(fx) mit einer PLC-Frequenz fx wird somit erst über den Transformator 4 von der Primärwicklung L1 auf die Sekundärwicklung L2 transformiert und von einer PLC-Empfangseinheit, z.B. als Teil der Auswerteeinheit 5, empfangen.

Der Transformator 4 kann auch zur Erkennung eines Lichtbogens dienen, wie in Fig. 3 dargestellt. Bildet sich in einer Gleichspannungsquelle 2, einer Gleichspannungssenke 6, einer Gleichspannungsleitung DC+, DC- einer Steckverbindung der Gleichspannungsleitung DC+, DC-, oder dergleichen ein Lichtbogen aus, so entsteht in der Gleichspannungsleitung DC+, DC- ein Lichtbogensignal arc(f_arc) mit der Lichtbogenfrequenz f_arc. Die Lichtbogenfrequenz f_arc erstreckt sich beispielsweise über ein Frequenzspektrum von 5 kHz bis 200 kHz. Damit umfasst das Primärsignal i1 das Lichtbogensignal arc(f_arc). Beispielhaft ist in Fig. 3 der Lichtbogen arc als Blitz in der negativen Gleichspannungsleitung DC- gekennzeichnet. Der Transformator 4 transformiert das Primärsignal i1 auf das Sekundärsignal i2, welches damit auch ein Lichtbogensignal arc(f_arc) umfasst. Die Auswerteeinheit 5 umfasst hier also eine Lichtbogendetektionseinheit, und kann bei Auftreten eines Lichtbogens das Lichtbogensignal arc(f_arc) im Sekundärsignal i2 erkennen. Damit kann auf das Vorhandensein eines Lichtbogens arc geschlossen werden.

Die Erkennung des Fehlers F kann für eine Anordnung 1 mit einer Auswerteeinheit 5 umfassend eine Lichtbogendetektionseinheit und/oder PLC-Empfangseinheit analog wie in Fig. 1a, b beschrieben erfolgen - insbesondere wenn gar kein PLC-Empfangssignal Rx, bzw. Lichtbogensignal arc(f_arc) empfangen wird.

Wird jedoch ein PLC-Empfangssignal Rx (fx) empfangen, so umfasst das Sekundärsignal i2 natürlich das PLC-Empfangssignal Rx(fx). Sinnvollerweise weist das PLC-Empfangssignal Rx(fx) eine PLC-Frequenz fx auf, welche sich von der zumindest einen Frequenz fn unterscheidet, um die Fehlererkennung nicht durch die PLC-Frequenz fx zu stören. Diese Voraussetzung ist insbesondere bereits gegeben, wenn eine Rauschfrequenz als zumindest eine Frequenz fn verwendet wird, um zu vermeiden dass eine PLC-Kommunikation im Frequenzbereich des Rauschens stattfindet. Zudem ist bei einem Fehlerfall wie einer Unterbrechung einer Leitung oder Windung des Transformators 4 üblicherweise weder ein PLC-Empfangssignal Rx(fx), noch ein Signalanteil n(fn) im Sekundärsignal i2 vorhanden, womit schnell auf einen Fehler F geschlossen werden kann.

Es ist auch für die Lichtbogenerkennung vorteilhaft, wenn ein Lichtbogen arc die Fehlererkennung nicht stört, d.h. die Lichtbogenfrequenz f_arc des Lichtbogensignals arc(f_arc) nicht im Bereich der zumindest einen Frequenz fn liegt. Doch auch wenn ein Lichtbogensignal arc(f_arc) im Signalanteil n(f) liegen sollte, so wäre eine Erkennung des Fehlers F möglich, wenn bei einem Fehler F der Signalpegel P(fn) des Signalanteils n(fn) unter der Signalschwelle P_min(fn) liegt. Damit wäre zwar ggf. eine Detektion eines Lichtbogens arc nicht möglich, insbesondere wenn eine Windung des Transformators 4 oder eine Leitung unterbrochen defekt ist, und damit das Lichtbogensignal arc(f_arc) nicht an der Auswerteeinheit 5 ankommt. Dieser Fehler wird jedoch erfindungsgemäß durch die Fehlererkennungseinheit 7 erkannt, was auch im Betrieb der Anordnung möglich ist.

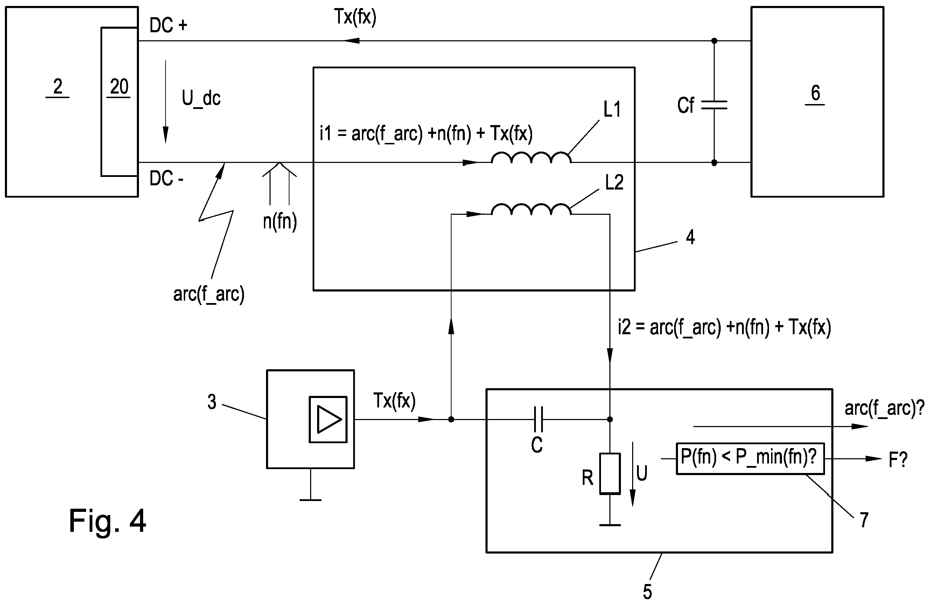

Es kann auch eine mit der Sekundärwicklung L2 verbundene Sendeeinrichtung 3 vorgesehen sein, um ein PLC-Sendesignal Tx(fx) mit einer PLC-Frequenz fx zu senden, wie in Fig. 4 dargestellt. Das PLC-Sendesignal Tx(fx) wird auf das Sekundärsignal i2 aufmoduliert und vom Transformator 4 auf das Primärsignal i1 transformiert. Das Primärsignal i1 wird in die Gleichspannungsleitung DC+, DC- eingekoppelt und über die Gleichspannungsleitungen DC+, DC- an die Gleichspannungsquelle 2 und/oder die Gleichspannungssenke 6 übertragen und von einer an der Gleichspannungsquelle 2 und/oder Gleichspannungssenke 6 vorgesehenen Empfangseinheit 20 empfangen und demoduliert. Auch bei einer Übertragung des PLC- Sendesignal Tx über die Gleichspannungsleitungen DC+, DC-, kann eine Filterkapazität Cf in oder an der Gleichspannungssenke 6 verwendet werden, um das PLC- Sendesignal Tx durch zu schleifen. Als PLC- Sendesignale Tx(fx) können beispielsweise Pulse zur Detektion von Störstellen, Signale zur Impedanzmessung, Störpegelmessungssignale, Synchronisationssignale für einzelne Stromquellen 2, wie Solarzellen, oder auch Steuersignale dienen.

PLC-Frequenzen fx für PLC-Empfangssignale Rx(fx), wie auch für PLC-Sendesignale Tx(f) befinden sich üblicherweise im Frequenzspektrum von 125 kHz bis 145 kHz, beispielsweise 131,25 kHz und 143,75 kHz.

Ganz besonders vorteilhaft ist Anordnung 1, mit einer Fehlerdetektionseinheit und einer Auswerteeinheit 5 zur Erkennung eines Lichtbogens arc, wobei zusätzlich eine Sendeinheit 3 zum Senden eines PLC-Sendesignals Tx(fx) vorgesehen ist. Der Transformator 4 kann somit für die PLC-Kommunikation, als auch für die Detektion eines Lichtbogens arc verwendet werden. Es ist möglich ein PLC-Sendesignals Tx(fx) durch die Sendeeinrichtung 3 zu senden und gleichzeitig durch eine Lichtbogendetektionseinheit, z.B. als Teil der Auswerteeinheit 5, einen Lichtbogen arc zu erkennen. Fig. 4 zeigt eine vorteilhafte Ausgestaltung der Erfindung, die eine Erkennung eines Lichtbogens arc über ein Lichtbogensignal arf(f_arc) und das Senden eines PLC-Sendesignals Rx(fx) ermöglich, wobei zudem eine Fehlererkennung 7 realisiert ist. Die Primärwicklung L1 ist mit der Gleichspannungsleitung DC+, DC- verbunden. Die Sekundärwicklung L2 ist mit der Auswerteeinheit 5 verbunden, welche hier grundsätzlich eine Lichtbogenerkennungseinheit darstellt und die Fehlerdetektionseinheit 7 umfasst. Um das PLC-Sendesignal Tx gegenüber dem Lichtbogensignal arc(f_arc) zu dämpfen, ist hier beispielhaft ein Widerstand R und eine in Serie geschaltete Kapazität C mit einer bevorzugten Größenordnung von 70 bis 120nF vorgesehen, wobei eine Grundfrequenz im kHz Bereich, vorzugsweise 130kHz vorgesehen sein kann. Die Kapazität C ist parallel zur Sekundärwicklung L2 geschaltet. Die Auswerteeinheit 5 umfasst weiters einen Widerstand R um eine das Sekundärsignal i2 auf eine am Widerstand R anliegende Spannung U zu wandeln und zur Erkennung des Lichtbogens arc zu verarbeiten. Gleichermaßen wird das Sekundärsignal i2 über die Spannung U zur Erkennung des Fehler F verwendet, indem der Signalpegel P(fn) des Signalanteils n(fn) bei der zumindest einen Frequenz fn betrachtet und mit der Signalschwelle P_min(fn) verglichen wird.

Da die Sendeinheit 3 ebenso in Serie zur Sekundärwicklung geschaltet ist, wird somit ein Resonanzkreis erzeugt, welcher aus Sicht der Auswerteeinheit 5 (samt der Fehlererkennungseinheit 7) ein um bis zu 1/10 gedämpftes PLC-Sendesignal Tx(fx) gegenüber dem Signalteil n(fn), und dem Lichtbogensignal arc(f_arc) bewirkt. Damit ist insbesondere auch bei Senden eines PLC-Sendesignals Tx(fx) eine sichere Erkennung eines Lichtbogens arc, wie auch eines Fehlers F möglich. Die in Fig. 4 dargestellte Ausgestaltung ist natürlich auch ohne eine Lichtbogenerkennung möglich. Damit kann also auch ein Transformator 4, welcher eine mit der Sekundärwicklung L2 verbundene Sendeinheit 3 für eine PLC-Kommunikation aufweist, auf Funktion, bzw. Fehler F getestet werden, ohne das Vorhandensein einer Lichtbogendetektionseinheit. Der Signalanteil n(fn) kann natürlich auch durch ein Rauschen der Auswerteeinheit 5 selbst entstehen. Somit kann auch auf einen Fehler in der Auswerteeinheit geschlossen werden.

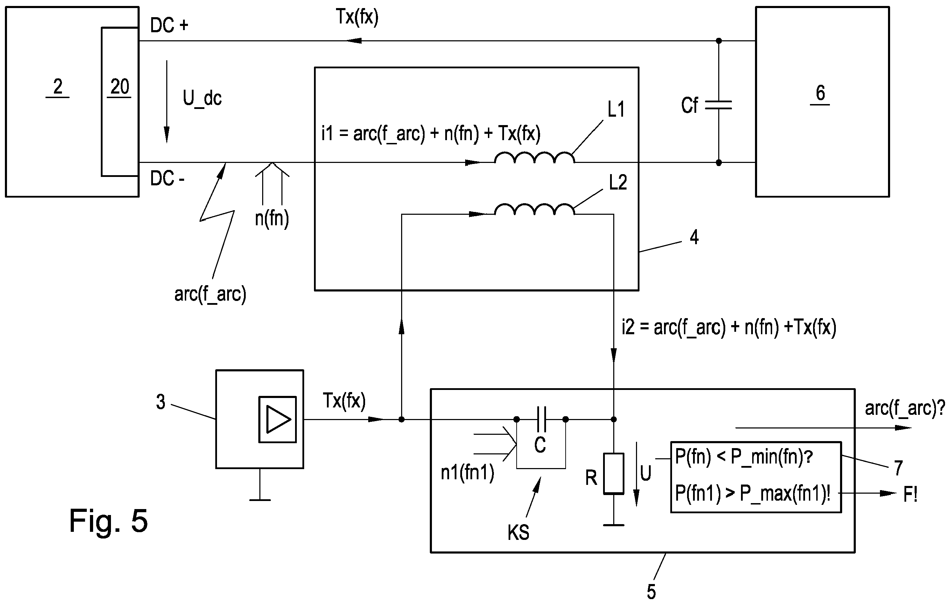

Es kann aus dem Sekundärsignal i2 ein weiterer Signalanteil n1(fn1) bei zumindest einer weiteren Frequenz fn1 ermittelt werden und ein Signalpegel P(fn1) des weiteren Signalanteils n1 (fn1) mit einer oberen Signalschwelle P_max(fn1) verglichen werden. Es wird ein Fehler F in der Anordnung 1 detektiert, wenn der Signalpegel P(fn) die obere Signalschwelle P_min(fn1) überschreitet. In Fig. 5 ist der eine fehlerhafte Anordnung 1 dargestellt, welche einen Kurzschluss KS des Kondensators C der Auswerteeinheit 5 als Fehler F aufweist. Der Kurzschluss KS schließt hier ebenso die Sekundärwicklung L2 kurz. Damit ist aufgrund des Kurzschlusses KS der Signalpegel P(fn1) eines weiteren Signalteils n1 (fn1) bei einer weiteren Frequenz fn1 über einer oberen Signalschwelle P_max(fn1) und es kann auf einen Fehler F, hier den Kurzschluss KS geschlossen werden. Der Kurzschluss KS des Kondensators C ist natürlich nur beispielhaft aufgeführt, es können auch weitere Kurzschlüsse KS oder andersartige Fehler in der Auswerteeinheit 5 oder anderen Elementen der Vorrichtung 1 erkannt werden.

Die Signalschwelle P_min(fn) und/oder die obere Signalschwelle P_max(fn1) können für unterschiedliche Frequenzen fn, bzw. weitere Frequenzen fn1 variieren, insbesondere wenn angenommen werden kann, dass Fehler F die Pegel P(fn), P(fn1) bei unterschiedlichen Frequenzen fn, bzw. weiteren Frequenzen fn1 unterschiedlich beeinflussen. Entspricht die weitere Frequenz fn1 der Frequenz fn, so wird kein Fehler detektiert, wenn der Signalpegel P(fn), P(fn1) zwischen der unteren Signalschwelle P_min(fn) und der oberen Signalschwelle P_max(fn1) liegt. Ist der Signalpegel P(fn), P(fn1) unter der unteren Signalschwelle P_min(fn) oder über der der oberen Signalschwelle P_max(fn1), so wird ein Fehler F detektiert.

Es kann auch angenommen werden, dass unterschiedliche Arten von Fehlern F in der Anordnung 1 die Signalpegel P(fn), P(fn1) von unterschiedlichen Signalanteilen n(fn) bei unterschiedlichen (weiteren) Frequenzen fn, fn1 absenken können. Damit kann auf unterschiedliche Arten von Fehlern F in der Anordnung 1 geschlossen werden, indem die Pegel P(fn), P(fn1) von unterschiedliche (weiteren) Signalanteilen n(fn), n1(fn1) bei unterschiedlichen (weiteren) Frequenzen fn, fn1 mit der Signalschwellen P_min(fn) bzw. der oberen Signalschwelle P_max(fn) verglichen werden.

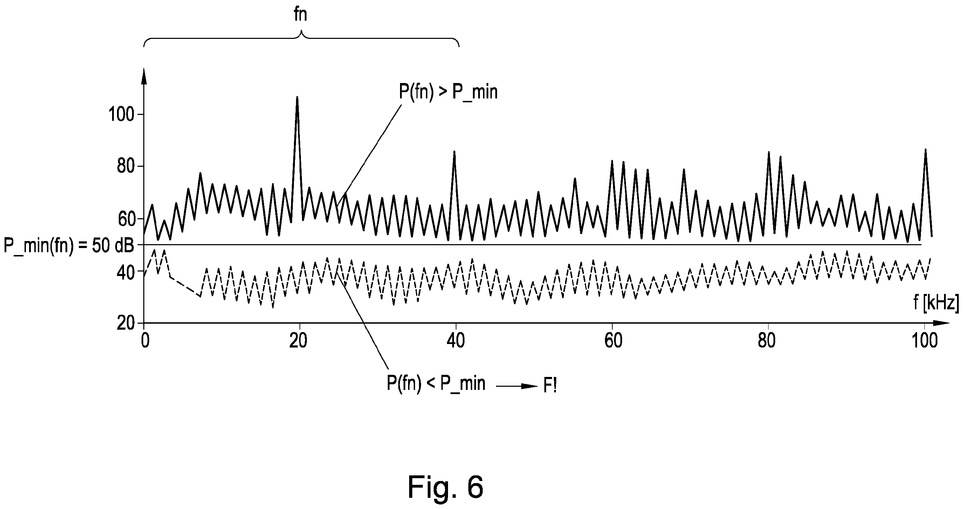

Fig. 6 zeigt einen typischen Verlauf des Sekundärsignals i2 im Frequenzbereich. Dabei ist beispielhaft das Frequenzband von 0 bis 40k kHz als Grenzfrequenz als Signalanteil n(fn) vorgesehen. Durchgezogen ist das Sekundärsignal i2 ohne auftretenden Fehler F dargestellt. Es ist ersichtlich, dass der Signalanteil n(fn) hier für alle Frequenzen fn über der Signalschwelle P_min(fn) liegt, womit darauf geschlossen werden kann, dass kein Fehler F in der Anordnung 1 auftritt.

Strichliert ist das Sekundärsignal i2 bei einem auftretenden Fehler F dargestellt. Der Signalanteil n(fn) des Sekundärsignals i2 bei auftretendem Fehler F weist gegenüber dem Signalanteil n(fn) ohne Fehler F einen geringeren Signalpegel P(fn) auf. Der Signalpegel liegt somit bei allen Frequenzen fn unter der Signalschwelle P_min(fn). Es kann somit darauf geschlossen werden, dass kein Fehler F in der Anordnung 1 auftritt.

Es kann der Mittelwert der Signalpegel P(fn) der Frequenzen fn des Frequenzbands gebildet werden und der Mittelwert mit der Signalschwelle P_min(fn) verglichen um Störungen einzelner Frequenzen fn auszumitteln. Somit werden nicht die Signalpegel (P(fn) einzelner Frequenzen fn betrachtet und ausgewertet, sondern der Gesamtenergieinhalt im Frequenzband. Der Mittelwert kann dabei ein arithmetischer Mittelwert, ein Median oder dergleichen sein.

Natürlich kann das Primärsignal i1 und das Sekundärsignal i2 neben dem Signalanteil n(fn), dem Lichtbogensignal arf(f_arc), dem PLC-Sendesignal Tx(fx), und PLC-Empfangssignal Rc(fx), weitere Anteile an Wechselströmen, z.B. weitere Signale, Störungen, etc. beinhalten.

## Patentansprüche

1. Verfahren zur Detektion eines Fehlers (F) in einer Anordnung, umfassend einen Transformator (2), welcher eine in Serie zu einer Gleichspannungsleitung (DC+, DC-) geschaltete Primärwicklung (L1) und eine mit der Primärwicklung (L1) magnetisch gekoppelte Sekundärwicklung (L2) aufweist, und umfassend eine Auswerteeinheit (5), welche ein Sekundärsignal (i2) auf der Sekundärwicklung (L2) verarbeitet, **dadurch gekennzeichnet, dass** aus dem Sekundärsignal (i2) ein Signalanteil (n(fn)) bei zumindest einer Frequenz (fn) ermittelt und ein Signalpegel (P(fn)) des Signalanteils (n(fn)) mit einer Signalschwelle (P_min(fn)) verglichen wird, **und dass** der Fehler (F) in der Anordnung (1) detektiert wird, wenn der Signalpegel (P(fn)) die Signalschwelle (P_min(fn)) unterschreitet.

2. Verfahren nach Anspruch 1, **dadurch gekennzeichnet, dass** als zumindest eine Frequenz (fn) zumindest eine an der Sekundärwicklung (L2) typisch auftretende Rauschfrequenz der fehlerfreien Anordnung (1) und als Signalschwelle (P_min(fn)) ein bei der typisch auftretenden Rauschfrequenz auftretender Rauschpegel der fehlerfreien Anordnung (1) herangezogen wird.

3. Verfahren nach Anspruch 1 oder 2, **dadurch gekennzeichnet, dass** der Signalanteil (n(fn)) bei einer Mehrzahl an Frequenzen (fn) eines Frequenzbandesermittelt und der Signalpegel (P(fn)) bei der Mehrzahl an Frequenzen (fn) jeweils mit einer Signalschwelle (P_min(fn)) verglichen wird.

4. Verfahren nach Anspruch 1 oder 2, **dadurch gekennzeichnet, dass** der Signalanteil (n(fn)) bei einer Mehrzahl an Frequenzen (fn) eines Frequenzbandes ermittelt, ein Mittelwert oder ein Median der Signalpegel (P(fn)) bei der Mehrzahl an Frequenzen (fn) gebildet und mit einer Signalschwelle (P_min(fn)) verglichen wird.

5. Verfahren nach Anspruch 3 oder 4, **dadurch gekennzeichnet, dass** das Frequenzband von 0 Hz bis zu einer Grenzfrequenz, vorzugsweise 40 kHz reicht.

6. Verfahren nach einem der Ansprüche 1 bis 5, **dadurch gekennzeichnet, dass** der Signalanteil (n(fn)) bei einem Start der Anordnung (1) ermittelt wird.

7. Verfahren nach einem der Ansprüche 1 bis 6, **dadurch gekennzeichnet, dass** die Auswerteeinheit (5) ein durch den Transformator (4) von der Primärwicklung (L1) auf die Sekundärwicklung (L2) transformiertes PLC-Empfangssignal (Rx) und/oder Lichtbogensignal (arc) empfängt und auswertet.

8. Verfahren nach einem der Ansprüche 1 bis 7 **dadurch gekennzeichnet, dass** ein PLC-Sendesignal (Tx) von einer Sendeeinheit (3) an die Sekundärwicklung (L2) gesendet und von der Sekundärwicklung (L2) auf die Primärwicklung (L1) transformiert wird.

9. Verfahren nach einem der Ansprüche 1 bis 8 **dadurch gekennzeichnet, dass** aus dem Sekundärsignal (i2) ein weiterer Signalanteil (n1(fn1)) bei zumindest einer weiteren Frequenz (fn1) ermittelt und ein Signalpegel (P(fn1)) des weiteren Signalanteils (n1(fn1)) mit einer oberen Signalschwelle (P_max(fn1)) verglichen wird, **und dass** der Fehler (F) in der Anordnung (1) detektiert wird, wenn der Signalpegel (P(fn1)) die obere Signalschwelle (P_min(fn1)) unterschreitet.

10. Verfahren nach Anspruch 9, **dadurch gekennzeichnet, dass** die weitere Frequenz (fn1) der Frequenz (fn) entspricht.

11. Anordnung (1) umfassend einen Transformator (2), aufweisend eine Primärwicklung (L1), welche in Serie zu einer Gleichspannungsleitung (DC+, DC-) geschaltet und aufweisend eine mit der Primärwicklung (L1) magnetisch gekoppelte Sekundärwicklung (L2) und umfassend eine Auswerteeinheit (5), welche ausgestaltet ist, ein Sekundärsignal (i2) auf der Sekundärwicklung (L2) zu verarbeiteten, **dadurch gekennzeichnet, dass** eine Fehlererkennungseinheit (7) vorgesehen ist, die mit der Sekundärwicklung (L2) verbunden ist, und ausgestaltet ist aus dem Sekundärsignal (i2) einen Signalanteil (n(fn)) bei zumindest einer Frequenz (fn) zu ermitteln, einen Signalpegel (P(fn)) des Signalanteils (n(fn)) mit einer Signalschwelle (P_min(fn)) zu vergleichen und einen Fehler (F) in der Anordnung (1) zu detektieren, wenn der Signalpegel (P(fn)) die Signalschwelle (P_min(fn)) unterschreitet.

12. Anordnung (1) nach Anspruch 11, **dadurch gekennzeichnet, dass** die Auswerteeinheit (5) eine Lichtbogendetektionseinheit und/oder eine PLC-Empfangseinheit umfasst, die ausgestaltet ist ein durch den Transformator (4) von der Primärwicklung (L1) auf die Sekundärwicklung (L2) transformiertes Lichtbogensignal (arc) und/oder PLC-Empfangssignal (Rx) zu empfangen.

13. Anordnung (1) nach Anspruch 8 oder 12, **dadurch gekennzeichnet, dass** eine Sendeeinheit (3) vorgesehen ist, die mit der Sekundärwicklung (L2) des Transformators (4) verbunden ist und ausgestaltet ist ein PLC-Sendesignal (Tx) an die Sekundärwicklung (L2) zu senden, **und dass** der Transformator (4) ausgestaltet ist das PLC-Sendesignal (Tx) von der Sekundärwicklung (L2) auf die Primärwicklung (L1) zu transformieren.

14. Anordnung (1) nach einem der Ansprüche 8 bis 13, **dadurch gekennzeichnet, dass** die Gleichspannungsleitung (DC+, DC-) zur Übertragung einer Gleichspannung (Udc) von zumindest einer Gleichspannungsquelle (2) an zumindest eine Gleichspannungssenke (6) vorgesehen ist.

15. Anordnung (1) nach einem der Ansprüche 8 bis 14, **dadurch gekennzeichnet, dass** die zumindest eine Gleichspannungsquelle (2) zumindest eine Photovoltaikzelle umfasst, **und dass** die zumindest eine Gleichspannungssenke (6) zumindest einen Wechselrichter umfasst.
